# FASCICULE DE BREVET EUROPEEN

(11) **EP 2 319 117 B1**
(45) Date de publication et mention de la délivrance du brevet: **11.07.2012**
(21) Numéro de dépôt: 09802485.4
(22) Date de dépôt: 17.07.2009
(51) Int. Cl.: H01M 8/04, G01R 15/22, H03M 1/60, H01M 10/48, G01R 19/252, G01R 31/36

(54) **DISPOSITIF POUR REPRESENTER NUMERIQUEMENT UNE TENSION**
VORRICHTUNG ZUR NUMERISCHEN DARSTELLUNG EINER SPANNUNG
DEVICE FOR NUMERICALLY REPRESENTING A VOLTAGE

(30) Priorité: 28.07.2008 FR 0855173
(43) Date de publication de la demande: 11.05.2011
(73) Titulaire: Peugeot Citroën Automobiles Société Anonyme, 78140 Velizy Villacoublay (FR); Commissariat à l'Énergie Atomique et aux Énergies Alternatives, 75015 Paris (FR)
(72) Inventeur: ROY, Francis, F-91940 Les Ulis (FR); DOLHAGARAY, Jean-Claude, 91400 Saclay (FR); GIRAUD, Alain, F-91400 Orsay (FR); JOFFRE, Francis, F-91440 Bures-sur-yvette (FR)
(74) Mandataire: Ménès, Catherine
(86) Numéro de dépôt international: PCT/EP2009/059264
(87) Numéro de publication internationale: WO 2010/012618

(56) Documents cités:
- EP-A2- 0 256 811
- JP-A- 56 098 936
- US-A1- 2005 058 885
- US-B1- 6 762 587

## Description

La présente invention concerne une méthode de mesure des tensions individuelles délivrées par les cellules élémentaires d'un générateur électrique. Elle est applicable à tous les domaines dans lesquels sont utilisés des générateurs électriques comportant plusieurs cellules élémentaires, comme les piles à combustible utilisées dans le domaine de l'automobile.

Certains générateurs électriques, comme par exemple les piles à combustible embarquées dans les véhicules automobiles, comportent une pluralité de cellules élémentaires. Des systèmes électroniques de diagnostic permettent de mesurer la tension aux bornes de ces cellules élémentaires. Ces systèmes de diagnostic doivent lire, traiter et transmettre ces mesures dans un contexte environnemental sévère, notamment un contexte embarqué. De plus, les exigences réglementaires et sécuritaires dans le domaine de l'automobile imposent une isolation galvanique de la pile jusqu'à 1500 V. Il s'agit là de l'un des problèmes techniqu es que la présente invention se propose de résoudre.

Certains systèmes de diagnostic embarqués actuels utilisent principalement un convertisseur analogique-numérique pour lire la mesure, un microcontrôleur pour établir un diagnostic et un convertisseur optoélectronique pour transmettre les données numérisées. Le système de diagnostic est alimenté par une source d'alimentation électrique externe, comme une batterie 12V, par l'intermédiaire d'un convertisseur DC/DC. En général, l'isolation galvanique est maîtrisée, même au-delà de 1500 V. L'utilisation d'un convertisseur analogique-numérique et d'un microcontrôleur permet de lire plusieurs cellules, en les multiplexant sur le ou sur les canaux du convertisseur analogique-numérique, le ou les canaux étant référencés à un même potentiel. La lecture est directe lorsque la pile n'est formée que d'un petit nombre de cellules, c'est-à-dire tant que la tension lue reste compatible avec la tension fournie par le convertisseur DC/DC. Mais lorsque le nombre de cellules devient important, il faut d'abord ramener les tensions à un niveau compatible avec le système de mesure, ceci grâce à des ponts de résistances. Il faut également gérer de nombreux multiplexeurs électromécaniques, avec toutes les difficultés inhérentes à l'acheminement d'un grand nombre d'informations : nombreux potentiels dans le routage, diaphonie, précision, commutations, etc. Il s'agit là encore de l'un des problèmes techniques que la présente invention se propose de résoudre.

D'autres systèmes de diagnostic embarqués actuels utilisent une source d'alimentation électrique externe et plusieurs convertisseurs DC/DC, afin de fournir plusieurs sources d'alimentation pour plusieurs systèmes de diagnostic autonomes fonctionnant en parallèle. Cette solution permet de regrouper les cellules en paquets, chaque paquet étant associé à un convertisseur DC/DC et à un microcontrôleur. Elle résout également le problème d'isolation galvanique jusqu'à 1500V, même dans le cas d'un grand nombre de cellules. Mais cette solution est pénalisante par son encombrement, notamment dans les domaines embarqués tels que celui de l'automobile. Il s'agit là encore de l'un des problèmes techniques que la présente invention se propose de résoudre. Cette solution est également pénalisante par le manque de précision et de fiabilité des mesures, qui est essentiellement dû à la complexité des traitements de données. En effet, dans le domaine de l'automobile par exemple, les traitements doivent prendre en compte le fait que la mesure des tensions peut être affectée par la présence des ponts diviseurs et des commutateurs utilisés pour mesurer des tensions parfois faibles et fluctuantes. Les traitements doivent aussi prendre en compte le vieillissement des composants durant toute la vie du véhicule. Ils doivent aussi être compatibles des principes de conditionnement des données dans le réseau utilisé pour transmettre les mesures, comme un réseau de type CAN par exemple (« Controller Area Network »). Il s'agit là encore de l'un des problèmes techniques que la présente invention se propose de résoudre.

Le document JP 56 098936 A décrit un dispositif comprenant deux convertisseurs tension-fréquence et deux compteurs. L'un des compteurs reçoit en entrée les signaux issus de l'un des convertisseurs et l'autre compteur reçoit les signaux issus de l'autre convertisseur. Par ailleurs, le document US 6 762 587 B1 décrit un dispositif pour mesurer les tensions individuelles de cellules d'une pile à combustible. Le dispositif comprend un convertisseur et un unique microprocesseur faisant office de compteur. Pour permettre le traitement de signaux issus de plusieurs cellules, le dispositif comprend un multiplexeur en amont du convertisseur et du microprocesseur.

L'invention a notamment pour but de pallier les inconvénients précités. A cet effet, l'invention a pour objet un dispositif pour représenter numériquement la tension d'un signal tel que défini dans la revendication 1.

Dans un mode de réalisation, il peut comporter des entrées-sorties contrôlables de type « tout ou rien » pour transmettre un signal de sélection, l'une des entrées-sorties contrôlables étant connectée au convertisseur tension-fréquence de manière à activer ledit convertisseur.

Avantageusement, il peut comporter un processeur pour activer ou désactiver les entrées-sorties contrôlables et/ou pour envoyer le nombre de transitions vers une mémoire et/ou vers un réseau de communication.

Par exemple, le compteur, les entrées-sorties contrôlables et le processeur peuvent faire partie d'un microcontrôleur.

Avantageusement, il peut être implanté sur un circuit imprimé, les signaux étant alors véhiculés par des pistes conductrices du circuit imprimé.

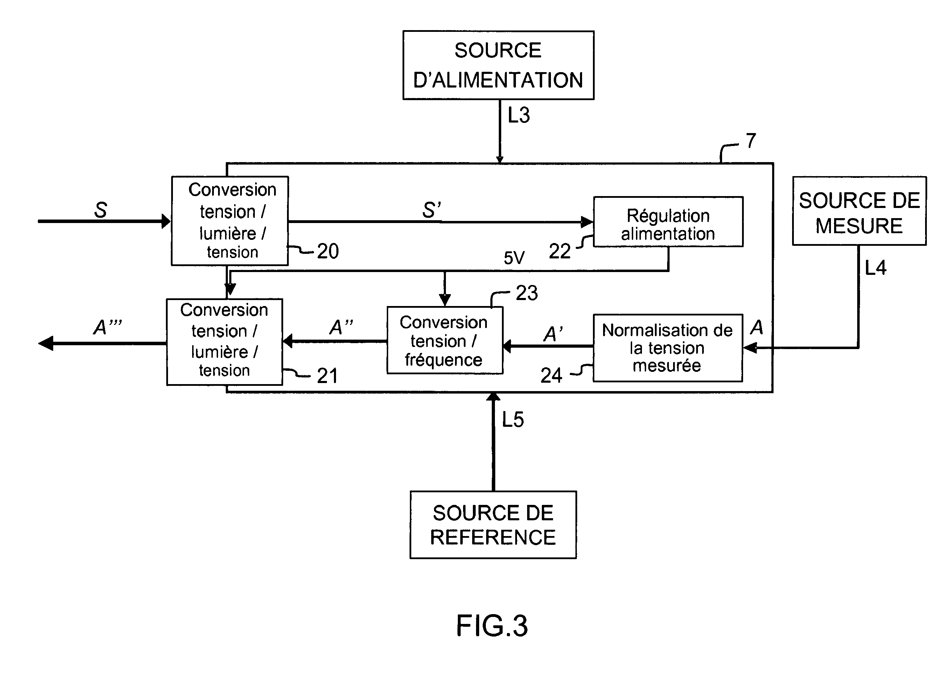

Le signal A (figure 3) peut être délivré par des cellules élémentaires d'un générateur, comme une pile à combustible utilisable pour alimenter la chaîne de traction d'une automobile par exemple.

Dans un mode de réalisation, des optocoupleurs peuvent convertir le signal de sélection et le signal analogique binarisé en signaux lumineux, puis convertir lesdits signaux lumineux en signaux électriques, de sorte à assurer l'isolation galvanique entre le microcontrôleur et la pile à combustible.

Le microcontrôleur peut comparer le nombre de transitions comptées à des seuils, de manière à élaborer un diagnostic sur l'état des cellules délivrant le signal.

L'invention a encore pour principaux avantages qu'elle permet d'utiliser le générateur lui-même pour alimenter les fonctions de mesure. Dans un contexte à pluralité de calculateurs comme une automobile, l'invention permet de doter la pile à combustible d'un capteur intelligent accessible par l'ensemble des calculateurs à travers un réseau CAN.

D'autres caractéristiques et avantages de l'invention apparaîtront à l'aide de la description qui suit faite en regard de dessins annexés qui représentent :
- la figure 1, par un synoptique, une illustration d'un principe d'alimentation sur lequel s'appuie l'invention, à partir d'un exemple de réalisation permettant de contrôler une pile à combustible utilisable dans un véhicule automobile ;
- la figure 2, par un synoptique, une illustration d'un exemple d'architecture fonctionnelle selon l'invention ;
- la figure 3, par un synoptique, une illustration d'un exemple d'architecture fonctionnelle d'une unité de mesure selon l'invention ;
- la figure 4, par un synoptique, une illustration d'un exemple d'architecture fonctionnelle d'un système centralisé de traitement et de diagnostic selon l'invention.

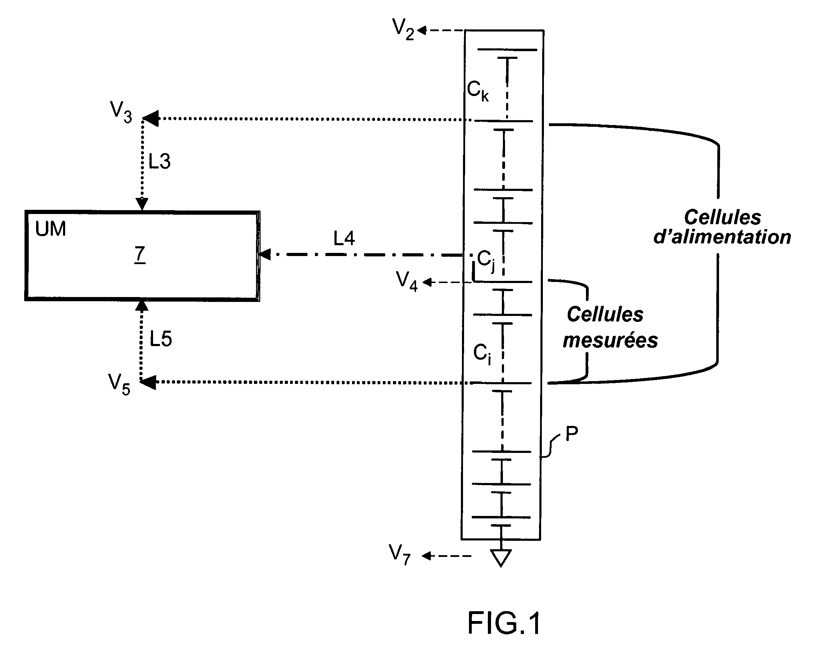

La figure 1 illustre par un synoptique un principe d'alimentation sur lequel s'appuie l'invention, à partir d'un exemple de réalisation permettant de contrôler une pile à combustible référencée P, la pile P étant utilisable dans un véhicule automobile. Ce principe d'alimentation fait par ailleurs l'objet d'une autre demande de brevet déposée par la demanderesse simultanément à la présente demande. La pile P comporte notamment N cellules élémentaires identiques connectées en série les unes aux autres. Sur la figure 1, les N cellules élémentaires sont référencées (Cm)_{1≤m≤N} dans l'ordre d'empilement. Chaque cellule comprend une plaque bipolaire et un assemblage membrane-électrodes. Dans un souci de simplification, la figure 1 illustre par exemple le cas où la pile P comporte N=10 cellules élémentaires connectées en série les unes aux autres. Mais dans la pratique, la pile P utilisée dans un véhicule automobile comporte plusieurs dizaines de cellules élémentaires. Chaque cellule dispose de plots de sortie, non représentés sur la figure 1, grâce auxquels il est possible de mesurer la tension délivrée par la cellule. La pile P délivre une tension V2 par rapport à un référentiel V7, V7 étant le référentiel de tension fixe de la pile P. La tension V2 est la somme des tensions délivrées par chaque cellule élémentaire.

Avantageusement, le présent exemple de réalisation peut être implémenté sur un circuit imprimé, de manière à former une carte électronique. Par exemple, la carte de diagnostic peut accéder aux plots de sortie des cellules par l'intermédiaire de limandes souples, non représentées sur la figure 1. Du même coup, la carte de diagnostic a alors potentiellement à sa disposition une pluralité de sources de courant, plus exactement une source en regard de chaque plaque bipolaire. Et la carte de diagnostic peut utiliser ces sources pour alimenter des systèmes électroniques, ceci dès l'instant que les courants d'alimentation qu'elle dérive ne remettent pas en cause la fonction même de la pile P, qui est de servir de générateur électrique à une chaîne de traction. Or, la pile P débite en mode nominal plusieurs dizaines d'ampères pour la chaîne de traction, alors qu'un système électronique embarqué n'utilise que quelques dizaines de milliampères. Notamment, le courant nécessaire à une mesure de tension ne pénalise pas le rendement de la pile P. C'est pourquoi il est envisageable d'utiliser la tension délivrée par une ou plusieurs cellules contiguës pour alimenter une unité de mesure (UM) référencée 7 sur la figure 1. Mais cela n'est pas sans poser des difficultés, le nombre de cellules servant à l'alimentation de l'unité de mesure 7 devant être suffisant pour garantir le niveau de tension nécessaire pour alimenter l'ensemble des composants électroniques de l'unité de mesure 7.

Par exemple, l'unité de mesure 7 peut être alimentée par une alimentation flottante V3 par rapport à un référentiel flottant V5. Le référentiel flottant V5 peut être formé en connectant l'unité de mesure 7 à l'une quelconque des cellules élémentaires. Par exemple, le référentiel flottant V5 peut être formé en connectant l'unité de mesure 7 à une cellule Ci où 1≤i≤N. L'alimentation flottante V3 par rapport au référentiel flottant V5 peut être formée en connectant par exemple l'unité de mesure 7 à une cellule Ck où 1≤k≤N, de sorte que la tension V3 est délivrée par k-i cellules élémentaires connectées les unes aux autres. Le nombre k-i est déterminé par la tension minimale nécessaire à la mise en état de fonctionnement de l'unité de mesure 7. Les k-i cellules de la cellule Ci à la cellule Ck sont les cellules d'alimentation. Par exemple, en connectant l'unité de mesure 7 à une cellule élémentaire Cj, où j est compris entre i et k, l'unité de mesure 7 peut lire une tension V4 par rapport au référentiel flottant V5. La tension V4 est délivrée par j-i cellules élémentaires connectées les unes aux autres. La tension V4 correspond en fait au différentiel de tension entre le référentiel flottant V5 et la cellule Cj. Les j-i cellules allant de la cellule Ci à la cellule Cj sont les cellules mesurées. Une cellule élémentaire peut donc jouer trois rôles : le rôle de référentiel flottant V5, le rôle d'alimentation flottante V3 par rapport au référentiel flottant V5 ou encore le rôle de source de tension V4 à mesurer. Le triple rôle d'une cellule permet de rendre totalement autonome la lecture et au moins une conversion de la tension V4. Il faut entendre par totalement autonome le fait que tout s'exécute sans autre apport de courant que celui fourni par l'alimentation flottante V3, c'est-à-dire sans avoir recours à des sources externes à la pile P. Le fait de disposer d'une source d'alimentation autonome prise directement sur les cellules de la pile P permet de concevoir un système de diagnostic dans l'environnement immédiat de la pile P, ainsi que de s'affranchir de toute source d'alimentation externe et des fortes contraintes d'isolation qui en découlent.

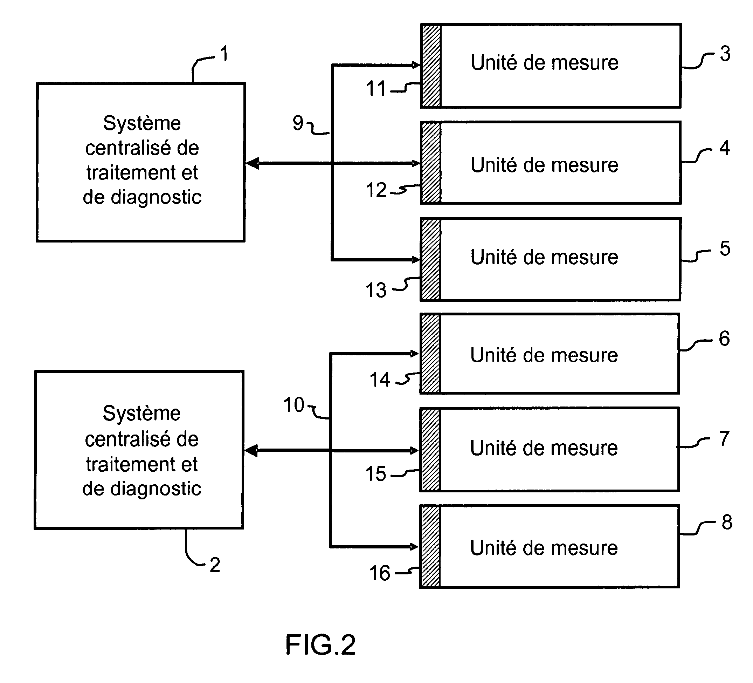

La mesure de la tension V4 délivrée par les cellules Ci à Cj peut par exemple s'effectuer en trois étapes. Une première étape peut permettre d'établir un lien L3 d'alimentation, un lien L4 de mesure et un lien L5 de référence, les liens L3, L4 et L5 connectant l'unité de mesure 7 aux trois cellules Ck, Cj et Ci respectivement. Une deuxième étape peut permettre de lire et de traiter la tension V4 mesurée. Une troisième étape peut permettre de rompre les liens L3, L4 et L5 afin de déconnecter l'unité de mesure 7 des cellules Ck, Cj et Ci. Ce principe de fonctionnement en trois étapes permet de mesurer la tension délivrée par n'importe quel autre groupe de cellules. Il peut se répéter à l'ensemble des cellules de la pile P, pour un nombre quelconque de cellules mesurées et pour un nombre quelconque de cellules d'alimentation. L'implantation sur une pile dépendra donc non seulement du nombre de cellules élémentaires formant la pile P, mais également des paramètres à mesurer et des exigences que cela représente en termes d'alimentation, d'agencement des différents composants et plus globalement de la fiabilité du système de mesures à développer. Par exemple, dans le cas où la compacité de la pile P ne permettrait pas un accès individuel à chacune des cellules élémentaires, la pile P peut avantageusement être considérée comme deux demi-piles entrelacées, deux cellules contiguës appartenant alors à deux piles virtuelles distinctes. Cela permet non seulement de limiter les croisements et les accumulations de fils, mais aussi d'éviter un routage trop complexe du circuit imprimé formant la carte. Dans ce cas, la carte de diagnostic peut comporter une pluralité d'unités de mesure identiques à l'unité 7, chaque unité de mesure ne procédant qu'à la lecture d'une paire de cellules contiguës. La détermination de la tension individuelle est alors reportée sur des modules de traitement de niveau supérieur, comme illustré par la figure 2.

La figure 2 illustre par un synoptique un exemple d'architecture fonctionnelle selon l'invention, applicable au présent système de diagnostic et pouvant être implémentée sur la carte. Des systèmes centralisés de traitement et de diagnostic 1 et 2 sont connectés à des unités de mesure 3, 4, 5, 6, 7 et 8 par l'intermédiaire de liens de transfert 9 et 10. Des barrières d'isolation galvanique 11, 12, 13, 14, 15 et 16 sont formées par des optocoupleurs intégrés aux unités de mesure 3, 4, 5, 6, 7 et 8 respectivement, comme explicité par la suite.

La figure 3 illustre l'architecture fonctionnelle d'une unité de mesure selon l'invention, l'unité 7 par exemple. Comme explicité précédemment, l'unité 7 est reliée au lien L3 d'alimentation, au lien L4 de mesure et au lien L5 de référence. L'unité de mesure 7 peut avantageusement comporter deux optocoupleurs 20 et 21 formant la barrière d'isolation galvanique 15. Un optocoupleur transforme un signal électrique en un signal lumineux, qui est ensuite détecté par un photocomposant et transformé à nouveau en un signal électrique. Ce transfert lumineux assure une très bonne isolation galvanique. Néanmoins, ce mécanisme reste sensible à la température. C'est pourquoi l'optocoupleur 21, qui transmet la mesure de tension en sortie de l'unité de mesure 7, ne peut garantir une mesure fiable de la tension des cellules, notamment si les exigences en matière de précision sont très strictes. Cependant, il existe une forme de signal qui n'est pas sensible à la température dans un optocoupleur, c'est le signal de type analogique binarisé en créneau oscillant entre deux états 0V et xV, où x est un réel non nul. Fonctionnant en mode bloqué/saturé, un optocoupleur transforme bien un créneau de tension [0V, xV] en un autre créneau [0V, xV]. C'est ce mode de fonctionnement qui est retenu dans le présent exemple pour les optocoupleurs 20 et 21. Par conséquent, la tension délivrée par les j-i cellules Ci à Cj, reçue par le lien L4, doit être convertie en un signal analogique binarisé, la fréquence du signal binarisé étant proportionnelle à la tension délivrée. A cet effet, l'unité de mesure 7 peut intégrer un convertisseur tension-fréquence 23. Un convertisseur tension-fréquence est un composant électronique dont la simplicité, la robustesse, la fiabilité, la faible sensibilité à l'environnement et la très bonne linéarité rendent tout à fait apte à répondre aux contraintes de l'unité de mesure 7. Il s'agit là d'une première étape de codage selon l'invention. Ainsi, le signal fourni en sortie par l'unité de mesure 7 est un signal analogique binarisé dont le nombre de transitions, c'est-à-dire le nombre de fronts, ou encore le nombre de paliers haut et bas par seconde, est proportionnel à la tension délivrée par les j-i cellules Ci à Cj. C'est cette caractéristique qu'utilise le système centralisé 2 connecté à l'unité de mesure 7. Le système centralisé 2 est implémenté dans un microcontrôleur de technologie récente plus spécifiquement dédiée à l'automobile. Un tel microcontrôleur dispose d'un très grand nombre d'entrées-sorties, qui fournissent notamment des fonctions de comptage. Il peut ainsi réaliser, de manière simultanée, le comptage de signaux binarisés issus de plusieurs unités de mesure. Cela limite d'autant le recours à des multiplexeurs. Compte tenu de la robustesse et de la fiabilité intrinsèque à un tel microcontrôleur, compte tenu de la technologie récente avec lequel il est conçu, il peut être considéré qu'il offre une très bonne linéarité de conversion signal binarisé-comptage de fronts. Il s'agit là d'une deuxième étape de codage selon l'invention.

L'optocoupleur 20 et le convertisseur tension-fréquence 23 sont alimentés directement par la pile P, comme explicité précédemment. En général, de tels composants nécessitent une source d'au moins 5V. Dans le présent exemple de réalisation utilisant la pile à combustible P, cela correspond à au moins cinq cellules contiguës, chaque cellule délivrant 1 ,1 V en mode de fonctionnement nominal. Cependant, la tension délivrée par une cellule pouvant descendre à 0,3V, une vingtaine de cellules sont nécessaires pour alimenter ces composants. C'est pourquoi l'unité de mesure 7 comporte un régulateur d'alimentation 22 qui permet de maintenir une tension de 5V quelle que soit la tension délivrée par les cellules. Afin de limiter l'usage de multiplexeurs, les unités de mesure 3, 4, 5, 6, 7 et 8 sont reliées à leur source d'alimentation respective via le routage même du circuit imprimé sur lequel est implémentée la carte de diagnostic. Ainsi, toutes les unités de mesure 3, 4, 5, 6, 7 et 8 sont actives simultanément. Cependant, afin que les signaux émis puissent être collectés par les systèmes de traitement 1 et 2, ceux-ci doivent pouvoir sélectionner les unités de mesure qu'ils veulent lire, en autorisant ou non leur alimentation. Ainsi, l'unité de mesure 7 est commandée par un signal S de sélection transmis par le système centralisé 2. Lorsque le signal S de sélection de l'unité 7 est activé, il y a double conversion tension-lumière-tension par l'optocoupleur 20 pour franchir la barrière d'isolation galvanique 15. L'optocoupleur 20 transmet un signal de commande S' au régulateur 22. Le régulateur 22 passe alors de l'état « hors service », où il ne délivre pas de tension, à l'état « en service », où il délivre une tension régulée stable de 5V quelles que soient les fluctuations de tension sur les liens L3 et L5, ces fluctuations étant liées aux différents modes d'utilisation de la pile P. Lorsque le signal de sélection S est désactivé, le régulateur 22 ne délivre plus aucune tension. La source de tension mesurée sur le lien L4 est normalisée en un signal analogique A' par un module 24 de normalisation de tension, ceci afin d'avoir une plage de fluctuation compatible avec le convertisseur tension-fréquence 23 et l'optocoupleur 21. Une fois le convertisseur tension-fréquence 23 alimenté en 5V par le régulateur 22, il convertit le signal A' en un signal analogique binarisé A" dont la fréquence est directement liée à la tension délivrée par les cellules mesurées Ci à Cj. Après un délai d'attente de stabilité de la conversion, le signal A" subit une double conversion tension-lumière-tension par l'optocoupleur 21 pour franchir dans l'autre sens la barrière d'isolation galvanique 15. Un signal A"' correspondant à la tension mesurée aux bornes des cellules Ci à Cj est fourni en sortie de l'optocoupleur 21 et transmis au système centralisé 2.

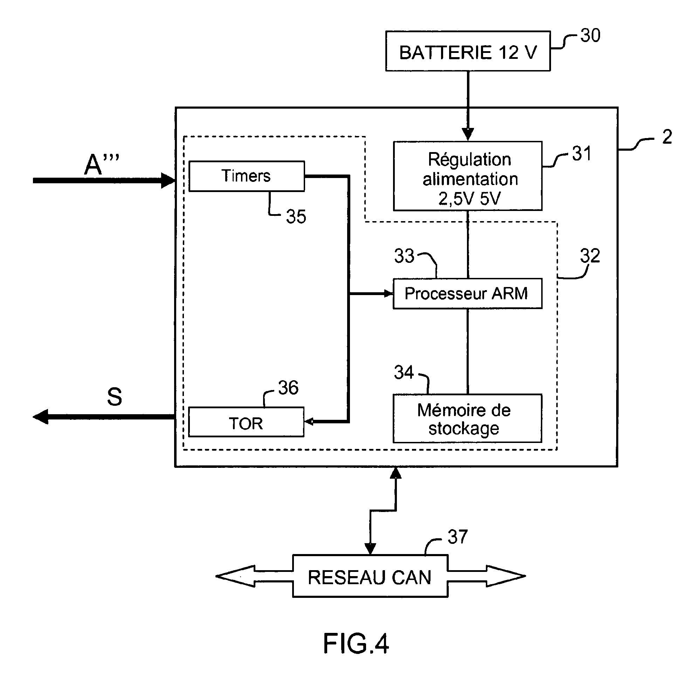

La figure 4 illustre l'architecture fonctionnelle d'un système centralisé de traitement et de diagnostic selon l'invention, le système centralisé 2 par exemple. Le système centralisé 2 est alimenté à partir d'une source externe 30, la batterie 12 V du véhicule par exemple. Dans le présent exemple de réalisation, le système centralisé 2 comporte par exemple un régulateur 31 permettant de réguler la tension d'alimentation, de sorte que celle-ci reste compatible des composants internes au système 2, comme un microcontrôleur 32 par exemple. Comme explicité précédemment, le microcontrôleur 32 est un microcontrôleur de technologie récente plus spécifiquement dédiée à l'automobile. Il permet l'émission du signal de sélection S et le codage en deux étapes de la tension mesurée A"'. Dans le présent exemple de réalisation, le microcontrôleur 32 dispose en interne d'un processeur 33 de technologie ARM (« Acorn RISC Machine »), de mémoires de stockage 34, d'une pluralité de compteurs 35 et d'une pluralité d'entrées-sorties 36 de type « tout ou rien » (TOR). Le processeur ARM 33 exécute un processus de traitement qui implémente l'invention. Ce processus comporte une étape de sélection de l'unité de mesure 7 et des cellules Ci à Cj à mesurer par activation d'une des entrées-sorties 36 de type TOR, de manière à transmettre vers l'unité de mesure 7 le signal de commande S. Le processus comporte également une étape de comptage par un des compteurs 35 des fronts ou des paliers présents par unité de temps dans le signal analogique binarisé A"' reçu en réponse au signal S. Le comptage commence après un délai d'établissement de la réponse et dure un temps d'ouverture qui dépend de la précision exigée. Le processus comporte une étape de désélection de l'unité de mesure 7 par désactivation de l'entrée-sortie 36 de type TOR. En fonction des algorithmes implémentés, le processeur 33 peut stocker dans la mémoire 34 la valeur comptée et/ou l'envoyer vers un poste de supervision par l'intermédiaire d'un réseau 37 de type CAN par exemple. Afin de bénéficier des pleines capacités du processeur ARM 33, la sélection de l'unité de mesure peut porter non pas sur l'unité 7 individuellement, mais plutôt sur une pluralité d'unités de mesure, chaque unité de mesure étant associée à un des compteurs 35.

Dans le présent exemple de réalisation, une sortie parmi les entrées-sorties TOR 36 peut être utilisée pour commander simultanément la mise en service et hors service d'une pluralité d'unités de mesure formant un paquet d'unités. Il y a donc autant de sorties affectées que de paquets de cellules nécessaires pour couvrir toutes les cellules de la pile P. Le signal de sélection S peut alors avantageusement être véhiculé par des pistes conductrices routées directement sur le circuit imprimé formant la carte de diagnostic, ce qui évite tout recours à des modules commandés de multiplexage

Dans le présent exemple de réalisation, le processeur ARM 33 peut disposer d'une douzaine de compteurs 35 pouvant fonctionner simultanément, de manière à limiter le temps de mesure global de l'ensemble des cellules de la pile P. Pour cela, plusieurs unités de mesure sont reliées à un même compteur parmi les compteurs 35. Pour assurer la cohérence des mesures, une seule unité à la fois délivre un signal du type du signal A", les autres présentant un état neutre n'affectant pas la mesure courante. Là aussi, les signaux du type du signal A" peuvent être véhiculés par des pistes conductrices routées directement sur le circuit imprimé formant la carte de diagnostic, ce qui évite une fois de plus tout recours à des modules de multiplexage.

Par exemple, le processeur ARM 33 peut implémenter une stratégie de diagnostic en comparant à des seuils le nombre de transitions obtenu par « double conversion » selon l'invention. Il faut comprendre que cette double conversion de la tension délivrée par les cellules Ci à Cj de la pile P n'a de sens que s'il est possible d'estimer la tension V4 à partir du nombre de transitions comptées, ceci avec une précision suffisante et quel que puisse être l'environnement en termes de température ou de comportement des cellules. Pour assurer cela, la carte de diagnostic peut faire l'objet d'un processus préalable d'étalonnage, permettant de retrouver les valeurs de tension V4 en fonction du nombre de transitions comptées.

L'invention décrite précédemment a encore pour principaux avantages qu'elle offre une excellente sûreté de fonctionnement par le choix des composants et la méthode de mesure des tensions par double conversion. Elle offre également une très bonne précision de mesure, notamment grâce au principe d'étalonnage. Sa modularité permet d'adapter très facilement le dispositif en fonction du nombre de cellules élémentaires formant le générateur, qu'il s'agisse d'électrolyseurs, d'éléments de batteries, de condensateurs ou encore de supercapacités.

## Revendications

1. Dispositif pour représenter numériquement la tension (V4) de signaux A, comportant :
- au moins deux convertisseurs tension-fréquence (23), chaque convertisseur tension-fréquence (23) permettant de convertir l'un des signaux A en un signal analogique binarisé A", la fréquence du signal analogique binarisé A" étant proportionnelle à la tension (V4) du signal A converti ;
**caractérisé en ce que** le dispositif comporte :
- des entrées-sorties contrôlables de type « tout ou rien » (36) pour transmettre un signal de sélection S, chaque entrée-sortie contrôlable étant connectée à au moins l'un des convertisseurs tension-fréquence (23) de manière à activer ou non l'un de ces convertisseurs (23) par le signal de sélection S transmis en autorisant ou non l'alimentation de ce convertisseur ;
- au moins un compteur (35) du nombre de transitions présentes par unité de temps dans le signal analogique binarisé A" du convertisseur tension-fréquence (23) activé, ledit nombre étant représentatif de la tension (V4) du signal A converti par le convertisseur tension-fréquence (23) activé.

2. Dispositif selon la revendication 1, **caractérisé en ce qu'**il comporte un processeur (33) pour activer ou désactiver les entrées-sorties contrôlables (36) et/ou pour lire et envoyer le nombre de transitions vers une mémoire (34) et/ou vers un réseau de communication (37).

3. Dispositif selon la revendication 2, **caractérisé en ce que** le compteur (35), les entrées-sorties contrôlables (36) et le processeur (33) font partie d'un microcontrôleur (32).

4. Dispositif selon la revendication 1, **caractérisé en ce qu'**il est implanté sur un circuit imprimé, les signaux S et A" étant véhiculés par des pistes conductrices du circuit imprimé.

5. Dispositif selon la revendication 1, **caractérisé en ce que** le signal A est délivré par des cellules élémentaires (Ci à Cj) d'un générateur (P).

6. Dispositif selon la revendication 5, **caractérisé en ce que** le générateur est une pile à combustible (P) utilisable pour alimenter la chaîne de traction d'une automobile.

7. Dispositif selon la revendication 6, **caractérisé en ce que** des optocoupleurs (20, 21) convertissent le signal de sélection S et le signal analogique binarisé A" en signaux lumineux, puis convertissent lesdits signaux lumineux en signaux électriques, de sorte à assurer l'isolation galvanique entre le microcontrôleur (32) et la pile à combustible (P).

8. Dispositif selon la revendication 3 et 5, **caractérisé en ce que** le microcontrôleur (32) compare le nombre de transitions comptées à des seuils, de manière à élaborer un diagnostic sur l'état des cellules (Ci à Cj) délivrant le signal A.

## Claims

1. A device for numerically representing the voltage (V4) of signals A, including:
- at least two voltage-frequency converters (23), each voltage-frequency converter (23) permitting one of the signals A to be converted into a binarized analogue signal A", the frequency of the binarized analogue signal A" being proportional to the voltage (V4) of the converted signal,
**characterized in that** the device includes:
- controllable input-outputs of the "all or nothing" type (36) to transmit a selection signal S, each controllable input-output being connected to at least one of the voltage-frequency converters (23) so as to activate or not one of these converters (23) by the selection signal S transmitted by authorizing or not the supply of this converter;
- at least one counter (35) of the number of transitions present per unit of time in the binarized analogue signal A" of the activated voltage-frequency converter (23), the said number being representative of the voltage (V4) of the signal A converted by the activated voltage-frequency converter (23).

2. The device according to Claim 1, **characterized in that** it includes a processor (33) for activating or deactivating the controllable input-outputs (36) and/or for reading and sending the number of transitions to a memory (34) and/or to a communication network (37).

3. The device according to Claim 2, **characterized in that** the counter (35), the controllable input-outputs (36) and the processor (33) form part of a microcontroller (32).

4. The device according to Claim 1, **characterized in that** it is installed on a printed circuit, the signals S and A" being conveyed by conductor traces of the printed circuit.

5. The device according to Claim 1, **characterized in that** the signal A is delivered by elementary cells (Ci to Cj) of a generator (P).

6. The device according to Claim 5, **characterized in that** the generator is a fuel cell (P) which is able to be used for supplying the power train of a motor vehicle.

7. The device according to Claim 6, **characterized in that** optocouplers (20, 21) convert the selection signal S and the binarized analogue signal A" into light signals, then convert the said light signals into electrical signals, so as to ensure the galvanic isolation between the microcontroller (32) and the fuel cell (P).

8. The device according to Claim 3 and 5, **characterized in that** the microcontroller (32) compares the number of transitions counted at thresholds, so as to form a diagnosis of the status of the cells (Ci to Cj) delivering the signal A.

## Patentansprüche

1. Vorrichtung zur numerischen Darstellung der Spannung (V4) von Signalen A, aufweisend:
- mindestens zwei Spannungs-Frequenzwandler (23), wobei jeder Spannungs-Frequenzwandler (23) es erlaubt, eines der Signale A in ein binarisiertes analoges Signal A" umzuwandeln, wobei die Frequenz des binarisierten analogen Signals A" zu der Spannung (V4) des umgewandelten Signals A proportional ist, **dadurch gekennzeichnet, dass** die Vorrichtung Folgendes aufweist:
- steuerbare Eingänge-Ausgänge des Typs "Alles oder Nichts" (36), um ein Auswahlsignal S zu übertragen, wobei jeder steuerbare Eingang-Ausgang an mindestens einen der Spannungs-Frequenzwandler (23) derart angeschlossen ist, dass einer dieser Wandler (23) durch das übertragene Auswahlsignal S aktiviert wird oder nicht, indem die Stromversorgung dieses Wandlers gestattet wird oder nicht;
- mindestens einen Zähler (13) der Anzahl der Übergänge, die pro Zeiteinheit in dem binarisierten analogen Signale A" des aktivierten Spannungs-Frequenzwandlers (23) vorliegen, wobei die Anzahl für die Spannung (V4) des von dem aktivierten Spannungs-Frequenzwandler (23) umgewandelten Signals A repräsentativ ist.

2. Vorrichtung nach Anspruch 1, **dadurch gekennzeichnet, dass** sie einen Prozessor (33) zum Aktivieren oder Deaktivieren der steuerbaren Eingänge-Ausgänge (36) und/oder zum Lesen und Senden der Anzahl von Übergängen zu einem Speicher (34) und/oder zu einem Kommunikationsnetz (37) aufweist.

3. Vorrichtung nach Anspruch 2, **dadurch gekennzeichnet, dass** der Zähler (35), die steuerbaren Eingänge-Ausgänge (36) und der Prozessor (33) zu einem Mikrocontroller (32) gehören.

4. Vorrichtung nach Anspruch 1, **dadurch gekennzeichnet, dass** sie auf einer Leiterplatte angeordnet ist, wobei die Signale S und A" durch Leiterbahnen der Leiterplatte befördert werden.

5. Vorrichtung nach Anspruch 1, **dadurch gekennzeichnet, dass** das Signal A von Elementarzellen (Ci bis Cj) eines Generators (P) gesendet wird.

6. Vorrichtung nach Anspruch 5, **dadurch gekennzeichnet, dass** der Generator eine Brennstoffzelle (P) ist, die zum Versorgen der Zugkette eines Kraftfahrzeugs verwendet werden kann.

7. Vorrichtung nach Anspruch 6, **dadurch gekennzeichnet, dass** Optokoppler (20, 21) das Auswahlsignal S und das binarisierte analoge Signal A" in Lichtsignale umwandeln, und dann die Lichtsignale in elektrische Signale umwandeln, so dass die galvanische Isolierung zwischen dem Mikrocontroller (32) und der Brennstoffzelle (P) sichergestellt ist.

8. Vorrichtung nach Anspruch 3 und 5, **dadurch gekennzeichnet, dass** der Mikrocontroller (32) die Anzahl von an Schwellen gezählten Übergängen vergleicht, um eine Diagnose des Zustands der Zellen (Ci bis Cj), die das Signal A liefern, zusammenzustellen.
